Europäisches Patentamt

European Patent Office

Office européen des brevets

(11) Veröffentlichungsnummer: **0 303 272**
**A2**

## (12) EUROPÄISCHE PATENTANMELDUNG

(21) Anmeldenummer: 88113075.1

(22) Anmeldetag: **11.08.88**

(51) Int. Cl.⁴: **H01L 25/04 , H01L 33/00**

(30) Priorität: **14.08.87 DE 8711105 U**

(43) Veröffentlichungstag der Anmeldung:
**15.02.89 Patentblatt 89/07**

(84) Benannte Vertragsstaaten:
**AT BE CH DE FR GB IT LI NL**

(71) Anmelder: **Siemens Aktiengesellschaft Berlin und München**
**Wittelsbacherplatz 2**
**D-8000 München 2(DE)**

(72) Erfinder: **Wehnelt, Ulrich, Dipl.-Phys.**
**Am Langenberg 2**
**D-8130 Starnberg II(DE)**

(54) **Leiterplatte für die Elektronik.**

㊼ Es soll eine einfache automatisierbare und wärmestabile Halbleiterkontaktierung für lineare und flächige SMD-Bauteile, insbesondere LED-Anordnungen verwirklicht werden. Hierzu werden auf eine mit Leiterbahnen beschichtete Trägerfolie SMD-Bauteile aufgesetzt, wobei die Leiterbahnen zur einfacheren Kontaktierung durch Aufschmelzen entweder ganz oder teilweise aus lötbarem Material bestehen.

# FIG 1

EP 0 303 272 A2

# Leiterplatte für die Elektronik

Die Erfindung bezieht sich auf eine Leiterplatte für die Elektronik insbesondere aus flexiblem Trägermaterial.

Es ist bekannt, Bauelemente auf der Oberfläche, die die Leiterbahnen trägt, unmittelbar mit den Leiterbahnen von oben her zu verlöten. Dies wird als SMD-Technik bezeichnet (SMD = Service Mounted Devices).

Der Erfindung liegt die Aufgabe zugrunde, eine einfache automatisierbare und wärmestabile Halbleiterkontaktierung sowohl für lineare als auch flächige Halbleiteranordnungen anzugeben.

Dies wird gemäß der Erfindung bei einer Anordnung der eingangs genannten Art dadurch gelöst, daß die Leiterbahnen zumindest an der Oberfläche, auf der sie mit den Bauelementen verbindbar sind, aus einem lötbaren Metall oder einer lötfähigen Legierung bestehen und daß die Bauelemente, insbesondere Halbleiter-Chips durch Schmelzen des lötbaren Materials mit den Leitern verbunden sind.

Weitere vorteilhafte Ausgestaltungen der Erfindung finden sich in den Unteransprüchen.

Nachstehend wird die Erfindung anhand von in den Figuren dargestellten Ausführungsbeispielen näher erläutert.

Figur 1 zeigt eine perspektivische Darstellung einer kontaktierten Lichtemissionsdiode in Folientechnik.

Figur 2 zeigt eine Zehnerzeile im Rastermaß 0,5 mm

Figur 3 zeigt ein Beispiel für eine versetzte Anordnung von Lichtemissionsdioden in einer 20-er Zeile

Figur 4 zeigt eien Querschnitt durch eine steckbare Anordnung.

Figur 5 zeigt eine alpha-numerische Anzeige in Stapeltechnik.

Figur 6 zeigt einen Querschnitt durch ein Element einer 2-Ebenen-Kontaktierung

Figur 7 zeigt eine Draufsicht auf zwei Elemente einer 2-Ebenen-Kontaktierung.

Auf eine flexible Kunststoff-Trägerfolie 1 (z.B. Polyäthylenterephthalat, Polyimid, Epoxidharz-Glasfasergewebe) wird eine dünne (ca. 1 μm) Kupferschicht 2 aufgebracht (stromlos beschichtet oder bedampft), die anschließend galvanisch auf ca. 5 μm verstärkt wird. Diese Verstärkung ist nötig, damit die Leiterbahnstruktur geätzt werden kann und zudem erhöht sie die Wärmeableitung aus der Kontaktzone. Nach dem Ätzen der gewünschten Leiterbahnen wird, ebenfalls galvanisch, eine ca. 5 - 20 μm dicke Zinn-Schicht 3 oder ein anderes lötbares Metall oder eine lötfähige Legierung abgeschieden. Die Kontaktierung des Bauelements 4, hier ein Halbleiterchip insbesondere eine LED (light emitting diode) wird - nachdem der Kristall an dem metallfreien Bereich so positioniert wurde, daß je ein Metallkontakt 6 des Halbleiters auf einer Leiterbahn 3 angeordnet ist - mit einem Lötstempel durchgeführt, durch den Einsinktiefe und Temperatur des Kristalls und der Druck auf den Kristall definiert eingestellt werden kann. Die Temperatur muß so gewählt werden, daß das Metall der Leiterbahn zum Schmelzen kommt und der Chip zur mechanischen Verankerung in die Trägerfolie einsinkt. Der pn-Übergang des Halbleiters ist mit 5 angedeutet.

Die Geometrie der Leiterbahnen, vor allem der Abstand, richtet sich nach den Abmessungen der zu kontaktierenden Halbleiter und nach der gewünschten Strombelastbarkeit des Bauelementes 4.

Es ist aber auch möglich, in eine mit einer Kunststoffolie kaschierte Cu-Folie die Leiterbahnen zu ätzen und zu verzinnen, um Halbleiterchips zu kontaktieren; so kann eine weitere Erhöhung der Wärmeableitung erzielt werden; allerdings müssen hierbei die Toleranzen, insbesondere der Abstand der Leiterbahnen und die Dicke des Chips, äußerst genau eingehalten werden.

Die gewünschte Leiterbahngeometrie für die Kontaktierung kann auch in einer lötfähigen Metallfolie (zum Beispiel Zinnfolie), die auf einer Trägerfolie kaschiert ist, geätzt werden. Dann sind keine weiteren Arbeitsgänge nötig.

Der Aufbau der Leiterbahnen aus leicht schmelzenden Schichten ist deshalb besonders vorteilhaft, da zusätzliche Maßnahmen gegen ein Kurzschließen des pn-Überganges des Halbleiters nicht nötig sind. Durch Schmelzen der Metalle (Sn oder SnPb-Legierung) und des Kunststoffes in der Umgebung des Kristalls wird auch eine Cu-Schicht aus der gefährdeten Zone beseitigt, indem diese Stoffe dem Druck durch den Kristall ausweichen. Ein wesentlicher Vorteil bei dieser Art zu kontaktieren ist, daß im Gegensatz zum nail-head-bonding nur ein Arbeitsschritt nötig ist, um p- und n-Seite 5 zu kontaktieren. Zudem bietet diese Methode die Möglichkeit, mehrere Kristalle gleichzeitig oder eine Halbleiterschaltung mit mehreren Anschlüssen in einem Arbeitsgang zu kontaktieren.

Als besonders vorteilhaft für die Legierungsbildung in der Kontaktzone hat es sich erwiesen, einen Halbleiterkristall zu benützen, der über den einlegierten ohmschen Kontakten eine zusätzliche Goldschicht 6 trägt.

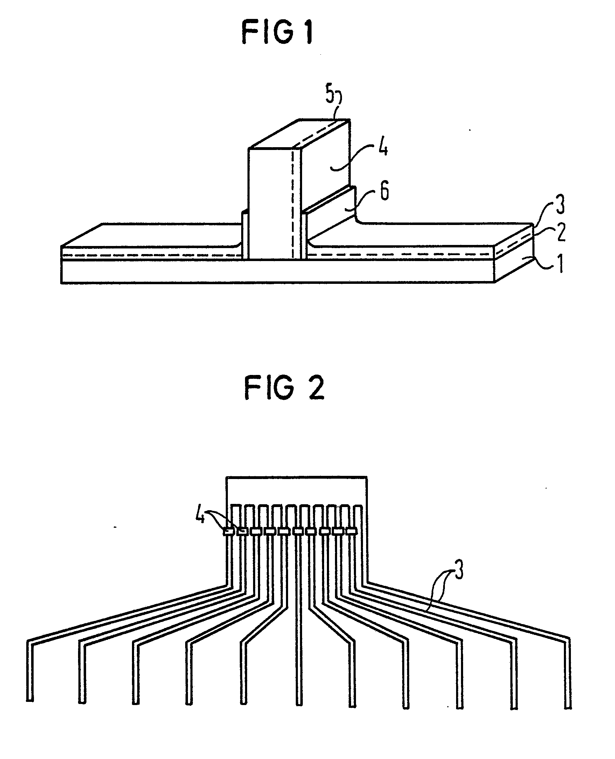

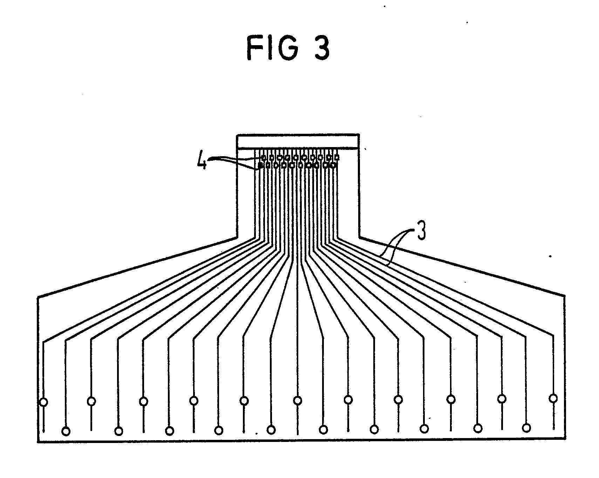

Für eine Zeilenanordnung, besonders bei geringem Abstand der einzelnen Bauelemente, ist die angegebene Kontaktierung sehr geeignet, da hier eine wesentlich engere Packung der Halbleiter möglich ist als in herkömmlicher Technik. Als Beispiel ist eine Zehnerzeile im Rastermaß 0,5 mm in Figur 2 und eine Anordnung mit zwanzig versetzten Dioden im Rastermaß 211 µm in Figur 3 angegeben.

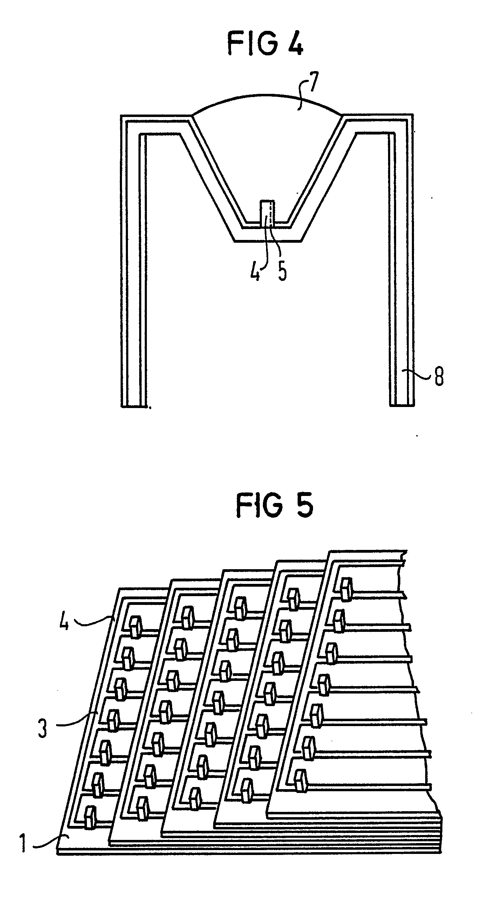

Falls ein steckbares Bauelement - sowohl ein Einzelelement als auch eine beliebige Mehrfachzeile - hergestellt werden soll, ist es möglich, den Kunststoffträger durch geeignete Verfahren (zum Beispiel Tiefziehen, Heißpressen) in eine solche Form zu bringen, Füßchen zu stanzen und dann den Halbleiter einzulöten, wie in Figur 4 dargestellt. Zur besseren Lötbarkeit der Füßchen 8 kann eine an diesen Stellen beidseitig mit Kupfer kaschierte Folie benützt werden (Figur 4). Die in dieser Figur 4 gezeigte Anordnung hat eine M-Form, wobei das Halbleiterbauelement 4 mit den äußeren Leiterbahnen 13 mittig verlötet ist und in eine Vergußmasse 7 eingebettet ist. Die innenseitigen Leiterbahnen 14 sind nur zur Erleichterung der Lötbarkeit mit der Leiterplatte vorgesehen.

Speziell für eine Lichtemissionsdioden-Anordnung als Matrix bietet diese Technik besondere Vorteile. Dieses als Stapeltechnik bezeichnete Verfahren führt zum Beispiel zu einer alphanumerischen Anzeige mit 5 mal 7 Lichtemissionsdioden im Rastermaß 1 mm wie in Figur 5 dargestellt. Dabei werden fünf Trägerfolien mit je sieben Lichtemissionsdioden so übereinander angeordnet und befstigt, daß auch zwischen den Zeilen ein Rastermaß von 1 mm entsteht.

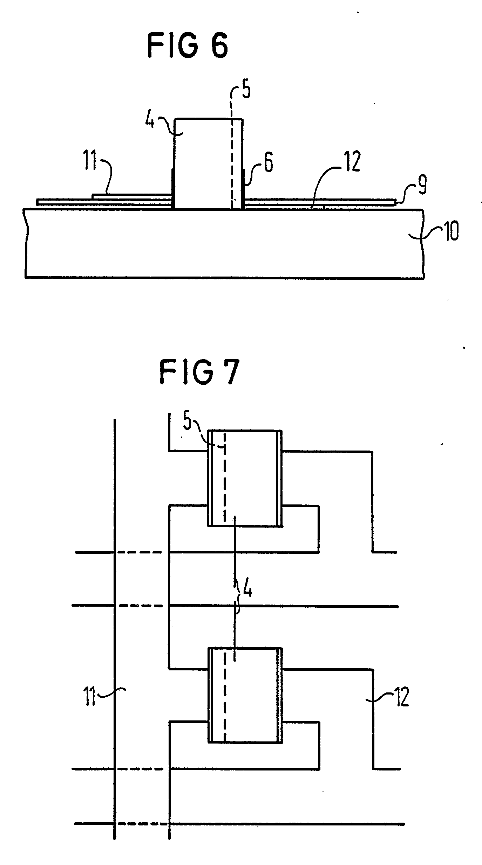

In Figur 6 ist eine weitere Möglichkeit zur Herstellung einer Matrix angegeben, wobei die Zuleitungen zu den Lichtemissionsdioden auf zwei Seiten einer dünnen Kunststoffolie 9 angeordnet sind. Dabei ist es möglich, in der Kontaktzone zu den Goldschichten 6 des Halbleiters auf der Innenseite eine ebene Leiterbahn 11 mit ihm zu verlöten und auf der anderen Seite eine untere Leiterbahn 12. Zur Versteifung ist die Trägerfolie mit den zwei Leiterbahnebenen auf einer dicken isolierenden Unterlage 10 aufgeklebt. Diese in Figur 6 als 2-Ebenen-Kontaktierung dargestellte Technik stellt eine Durchkontaktierung dar. Es werden auch hier die zwei Metallbeläge 6 des Halbleiters 4 in einem Arbeitsgang mit den zwei Zuleitungen 11, 12 auf den beiden Seiten der thermoplastischen Trägerfolie 9 verbunden.

## Ansprüche

1. Leiterplatte für die Elektronik insbesondere aus flexiblem Trägermaterial,
**dadurch gekennzeichnet,**
daß die Leiterbahnen zumindest an der Oberfläche, auf der sie mit den Bauelementen verbindbar sind, aus einem lötbaren Metall oder einer lötfähigen Legierung bestehen und aus die Bauelemente, insbesondere Halbleiter-Chips durch Schmelzen des lötbaren Materials mit den Leitern verbunden sind.

2. Leiterplatte nach Anspruch 1,
**dadurch gekennzeichnet,**
daß die Bauelemente, die als lineare oder flächige Halbleiter ausgebildet sind, an den Anschlußzonen mit einer lötbaren Metallschicht, insbesondere einer Goldschicht, versehen sind.

3. Leiterplatte nach Anspruch 1 oder 2,
**dadurch gekennzeichnet,**
daß die Bauelemente aus Lichtemissionsdioden (LED) bestehen.

4. Leiterplatte nach einem der vorhergehenden Ansprüche,
**dadurch gekennzeichnet,**
daß die Bauelemente auf den Leiterplatten zeilen- und spaltenförmig angeordnet sind.

5. Leiterplatte nach einem der vorhergehenden Ansprüche,
**dadurch gekennzeichnet,**
daß die Leiterplatten mit den Bauelementen mehrschichtig übereinander und versetzt angeordnet sind.

6. Leiterplatte nach einem der vorhergehenden Ansprüche,
**dadurch gekennzeichnet,**
daß die Bauelemente vorzugsweise mittels eines Lötstempels sowohl in die lötbare Schicht als auch in die Kunststoffunterlage eingeschmolzen sind.

7. Leiterplatte nach einem der vorhergehenden Ansprüche,
**dadurch gekennzeichnet,**
daß die Trägerfolien im Anschluß an das Bauelement wechselweise unterseitig und oberseitig mit Leiterbahnen versehen sind und zur Versteifung auf eine Trägerplatte kaschiert oder aufgeklebt sind.

# FIG 1

# FIG 2

# FIG 3

## FIG 4

## FIG 5

## FIG 6

## FIG 7